# EUROPEAN PATENT APPLICATION

(11) **EP 2 256 806 A2**
(43) Date of publication of application: **01.12.2010**
(21) Application number: 10250553.4
(22) Date of filing: 23.03.2010
(51) Int. Cl.: H01L 27/02

(54) **Semiconductor integrated circuit device**

(30) Priority: 28.05.2009 JP 2009128612
(71) Applicant: Renesas Electronics Corporation, Kawasaki-shi, Kanagawa (JP)
(72) Inventor: Hayashi, Yutaka, Tokyo 100-0004 (JP)
(74) Representative: Calderbank, Thomas Roger

(57) **Abstract**

The present invention provides a technique capable of realizing an ESD protection performance having a high ESD withstand voltage in a small layout area. An ESD protection circuit includes a clamping circuit, Zener diodes, a transistor comprised of a DMOS, a transistor comprised of an IGBT, and resistors. The ESD protection circuit effectively protects the protected circuit such that the transistor comprised of the DMOS is caused to absorb the current noise at the time of operating the protected circuit to prevent malfunction due to latchup and the IGBT (the transistor comprised of IGBT) whose current absorption capacity is increased by the thyristor effect is operated in parallel for a large current at the time of ESD.

## Description

### Cross-reference to related applications

The disclosure of Japanese Patent Application No. 2009-128612 filed on May 28, 2009 including the specification, drawings and abstract is incorporated herein by reference in its entirety.

The present invention relates to an electrostatic discharge (ESD) protection technique in a semiconductor integrated circuit device and, in particular, to an effective technique for ESD protection in a semiconductor integrated circuit device including a high voltage terminal to which a high voltage is applied.

In recent years, there has been growing demand for ESD withstand voltage for a high voltage terminal in a semiconductor integrated circuit device. Particularly, in an automobile, there has been growing demand for ESD withstand voltage in a semiconductor integrated circuit device to improve reliability and reduce the number of ESD protection components on an ECU.

For example, in an on-vehicle electronic control unit such as an airbag unit, airbags mounted on a vehicle tend to increase in number. Accordingly the number of ignition devices for the airbags increases. The airbag ignition device inflates or deploys an airbag by igniting the gunpowder. A squib driver flows current into a squib resistance to heat the squib resistance to ignite the gunpowder. So the squib driver is required to withstand a high voltage in an ECU for an automobile. The increase of the number of airbags also increases the number of squib drivers incorporated in a semiconductor integrated circuit device for inflating an airbag, which means that a lot of high withstand voltage terminals are necessary. Accordingly a lot of ESD protection circuits are necessary.

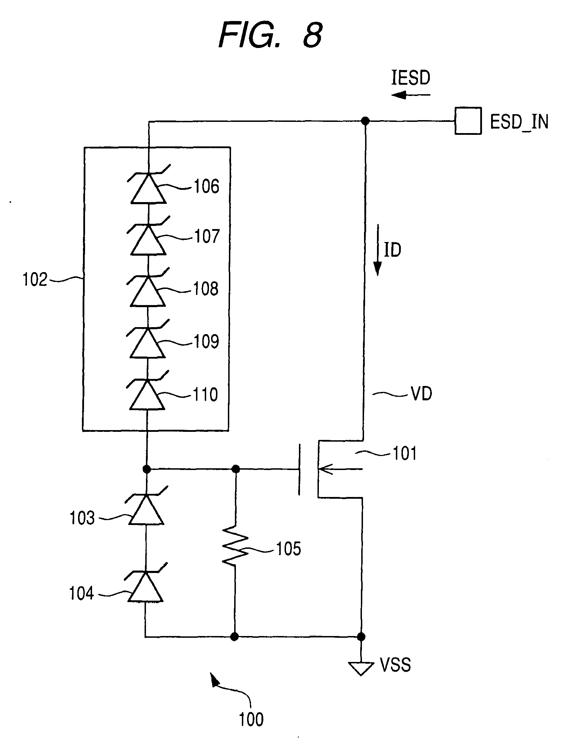

As shown in Fig. 8, for example, an ESD protection circuit 100 provided in the semiconductor integrated circuit device of this type includes a transistor 101, a voltage clamping circuit 102, Zener diodes 103 and 104, and a resistor 105.

The voltage clamping circuit 102 includes Zener diodes 106 to 110 coupled to each other in series, for example. The transistor 101 is comprised of a double diffused metal oxide semiconductor (DMOS) which absorbs ESD current, for example.

An external terminal ESD_IN being a high voltage terminal is coupled to the cathode of the Zener diode 106 and one coupling portion of the transistor 101. The anode of the Zener diode 110 is coupled to the gate of the transistor 101 and the cathode of the Zener diode 103.

The anode of the Zener diode 103 is coupled to the cathode of the Zener diode. The anode of the Zener diode 104, the other coupling portion of the resistor 105, and the other coupling portion of the transistor 101 are coupled to a reference potential VSS.

A clamping voltage in the voltage clamping circuit 102 including the Zener diodes 106 to 110 is taken as V1. The resistor 105 is a resistor for pulling down the gate to turn off the transistor 101 when ESD is not applied. The Zener diodes 103 and 104 are elements for protecting the gate of the transistor 101.

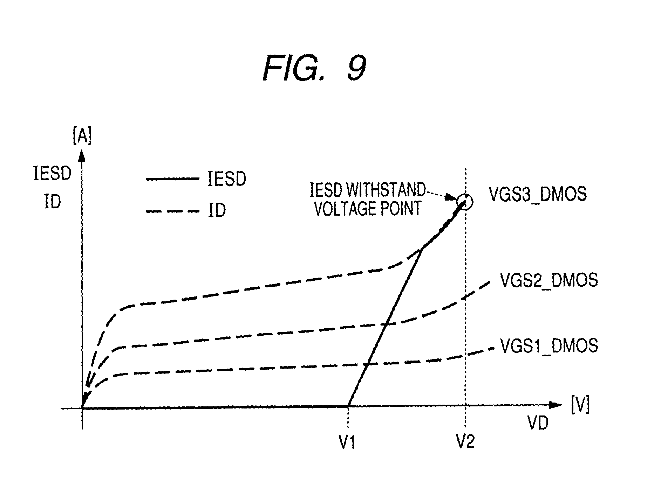

As shown in Fig. 9, the transistor 101 has a drain current (ID) and a drain voltage VD according to gate voltage VG (for example, VGS1_DMOS, VGS2_DMOS, and VGS3_DMOS).

If a withstand voltage of a protected circuit coupled to the external terminal ESD_IN is taken as (V2), the withstand voltage of the transistor 101 being a protection element is preferably equal to the withstand voltage (V2) of the protected circuit to effectively protect the breakdown of the protected circuit.

When ESD is applied on the external terminal ESD_IN whose maximum voltage is high, the drain voltage VD increase. And when the drain voltage VD exceeds the Zener voltage of the Zener diode 102, an ESD current IESD flows and certain amount of voltage is applied on the gate of the transistor 101, and the transistor 101 starts to turn on. Accordingly the most of the ESD current IESD flow on the drain of the transistor 101 as the drain current ID. At this time, the gate voltage VGS of the transistor 101 varies depending on the drain current ID. The larger the drain current ID, the higher the gate voltage VGS. Therefore, the clamping voltage is the sum of the gate voltage VGS and the Zener voltage of the Zener diode 102 according to the drain current ID.

The Zener diode 103 and the Zener diode 104 for limiting the gate voltage of the transistor 101 to the gate withstand voltage are coupled to each other to protect the gate of the transistor 101.

The dotted lines in Fig. 9 show the relation between the gate voltage VGS, the drain voltage VD, and the drain current ID of the MOS transistor. In other words, Fig. 9 shows a relation between the drain voltage VD and the drain current ID in three different gate voltages VG (VGS1_DMOS, VGS2_DMOS, and VGS3_DMOS). In Fig. 9, the drain current ID is substantially constant to the vicinity of the voltage V1 of the drain voltage VD and the drain current ID depends on the gate voltage VG. When the drain voltage VD exceeds the voltage V1, the drain current abruptly starts increasing. When the drain voltage VD reaches the drain voltage V2 being an IESD breakdown point, the MOS transistor breaks down.

For example, if the sum of Zener voltages of the Zener diode 103 and the Zener diode 104 for limiting the gate voltage of the transistor 101 to the gate withstand voltage is taken as VGS3_DMOS in Fig. 9, the ESD protection circuit in Fig. 8 has a characteristic indicated by the thick line in Fig. 9.

The present inventors found out the following problems in the ESD protection technique using the ESD protection circuit used in the aforementioned semiconductor integrated circuit device.

The size of the transistor 101 in the ESD protection circuit needs to be increased because the current capacity and breakdown strength of the transistor 101 itself absorbing the energy of ESD need to be increased, in order to improve the ESD withstand voltage of the external terminal ESD_IN.

As described above, in recent years, a demand for a high ESD withstand voltage and an increase in the number of high withstand voltage terminals increase the ratio of the area of an ESD protection element to that of the entire chip in the ESD protection circuit, resulting in increase in cost.

The preferred aim of the present invention is to provide a technique capable of realizing an ESD protection performance having a high ESD withstand voltage in a small layout area.

The above and further objects and novel features of the present invention will become apparent from the description of the present specification and the accompanying drawings.

A summary of the representative invention among the inventions disclosed in the present application is briefly described below.

According to an aspect of the present invention, there may be provided a semiconductor integrated circuit device provided with an ESD protection circuit for protecting against ESD at an input/output terminal thereof, wherein the ESD protection circuit includes: a first clamping circuit one terminal of which is coupled to the input/output terminal; a second clamping circuit one terminal of which is coupled to the output portion of the first clamping circuit; a third clamping circuit one terminal of which is coupled to the output portion of the second clamping circuit and the other terminal of which is coupled to a reference potential; a first transistor one coupling portion of which is coupled to the input/output terminal, the other coupling portion of which is coupled to the reference potential and the gate of which is coupled to the other terminal of the first clamping circuit; a second transistor one coupling portion of which is coupled to the input/output terminal, the other coupling portion of which is coupled to the reference potential and the gate of which is coupled to the other terminal of the second clamping circuit; a first resistor coupled between the gate of the first transistor and the reference potential; and a second resistor coupled between the gate of the second transistor and the reference potential.

The outline of the other inventions of the present application will be briefly described below.

In the present invention, the second transistor is any one of an insulated gate bipolar transistor (IGBT), a vertical double diffused MOS (VDMOS), a laterally diffused MOS (LDMOS), or a thyristor.

Furthermore, in the present invention, each of the first to the third clamping circuit includes one or more Zener diodes coupled in the reverse direction.

Still furthermore, in the present invention, each of the first to the third clamping circuit includes one or more diodes coupled in the forward direction.

Yet still furthermore, in the present invention, each of the first to the third clamping circuit includes one or more diodes in which a MOS transistor is diode-connected and which are coupled in the forward direction.

Advantages obtained by a representative invention among the inventions disclosed in present application will be briefly described below.
(1) The current absorption capacity can be increased while layout required for the ESD protection circuit is substantially decreased.
(2) The above advantage allows securing a high-performance ESD withstand voltage without a semiconductor integrated circuit device being increased in size, enabling the performance of the semiconductor integrated circuit device to be improved.

In the drawings:
Fig. 1 is a block diagram showing an example of an ECU module according to a first embodiment of the present invention;
Fig. 2 is a circuit diagram showing an example of an ESD protection circuit provided in the semiconductor integrated circuit device in Fig. 1;
Fig. 3 is a chart showing an example of an electrical characteristic of a transistor comprised of a DMOS provided in the ESD protection circuit in Fig. 2;
Fig. 4 is a chart showing an example of an electrical characteristic of a transistor comprised of an IGBT provided in the ESD protection circuit in Fig. 2;
Fig. 5 is a chart showing an example of an electrical characteristic in the ESD protection circuit in Fig. 2;
Fig. 6 is a cross section showing an example of the DMOS transistor provided in the ESD protection circuit in Fig. 2;
Fig. 7 is a cross section showing an example of the IGBT transistor provided in the ESD protection circuit in Fig. 2;
Fig. 8 is a circuit diagram showing an example of an ESD protection circuit in a semiconductor integrated circuit device studied by the present inventors; and
Fig. 9 is a chart showing an example of an electrical characteristic of a transistor provided in the ESD protection circuit in Fig. 8.

The embodiment of the present invention is described in detail below with reference to the drawings. The similar components in all the drawings for describing the embodiment are designated by the same reference numerals and characters in principle to omit the description thereof.

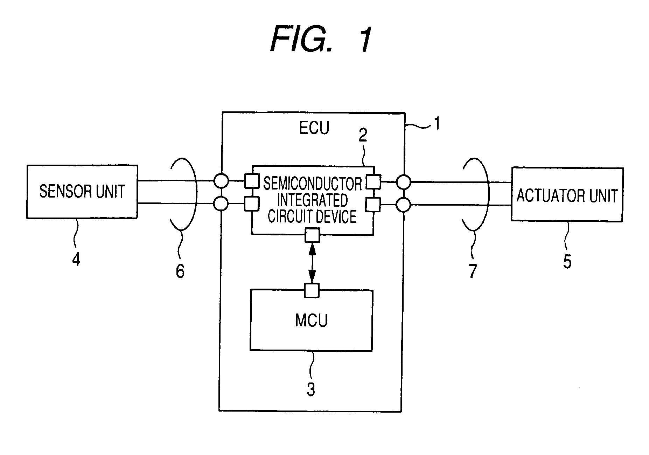

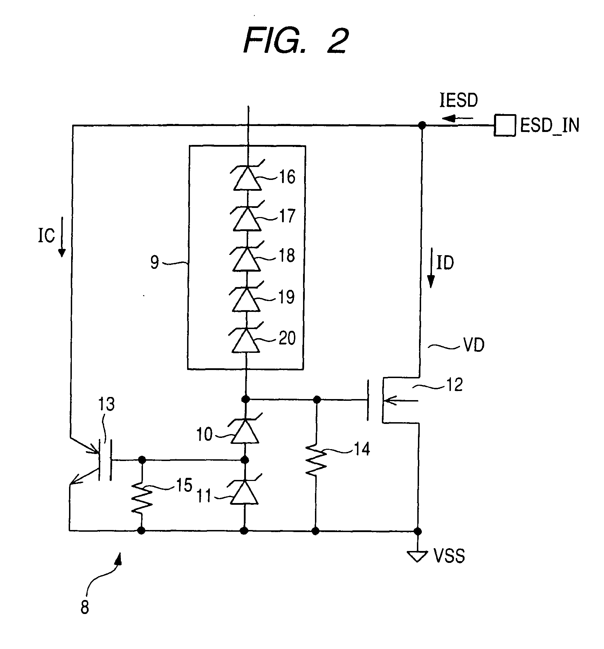

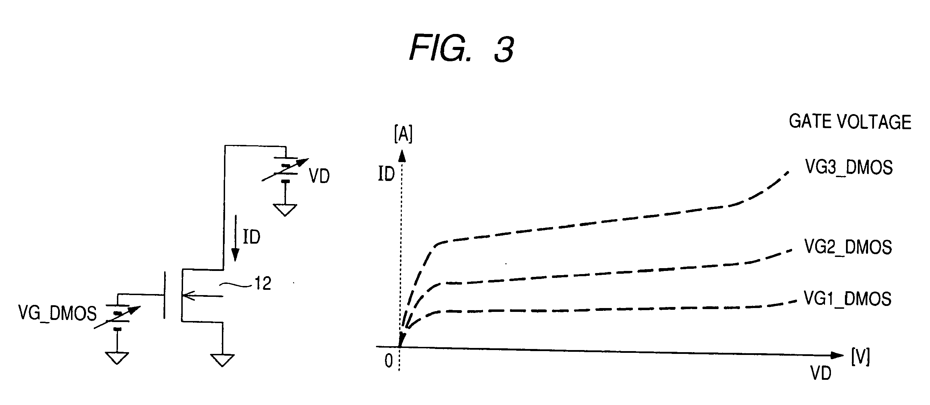

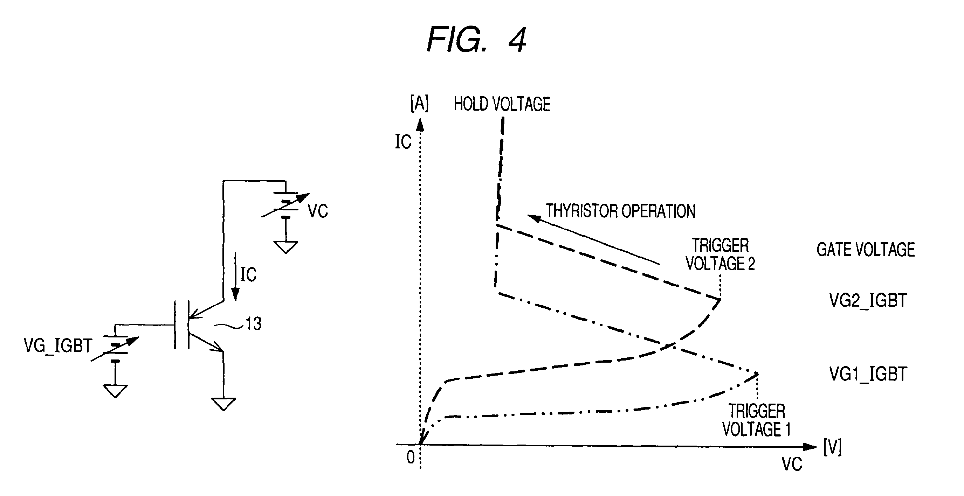

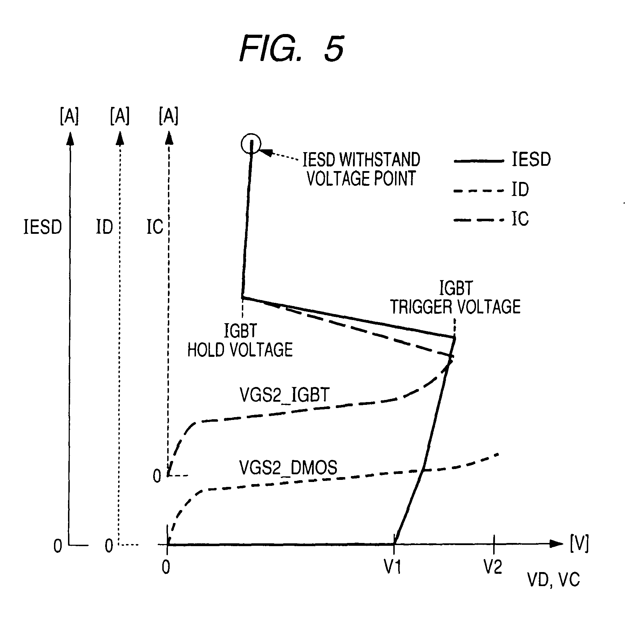

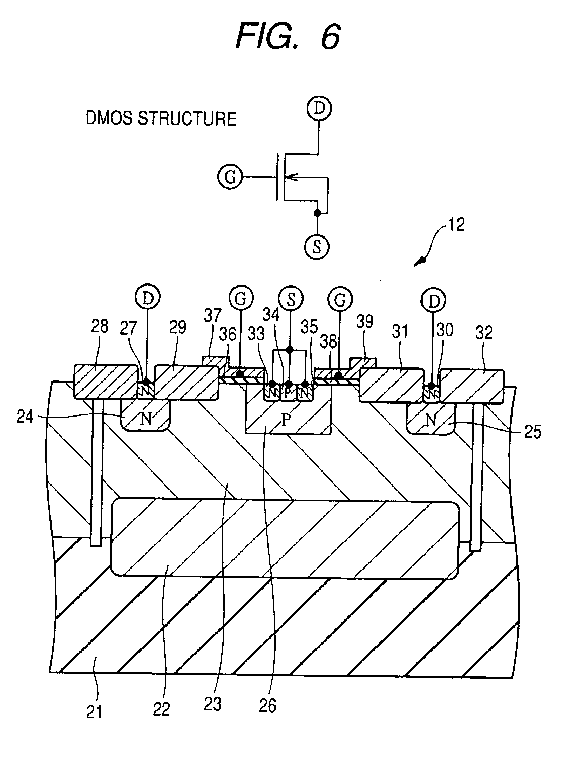

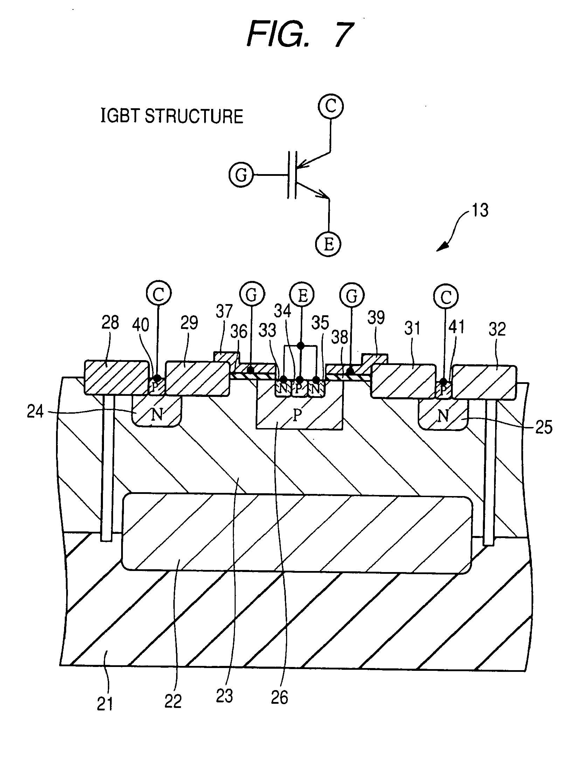

Fig. 1 is a block diagram showing an example of an ECU module according to a first embodiment of the present invention. Fig. 2 is a circuit diagram showing an example of an ESD protection circuit provided in the semiconductor integrated circuit device in Fig. 1. Fig. 3 is a chart showing an example of an electrical characteristic of a transistor comprised of a DMOS provided in the ESD protection circuit in Fig. 2. Fig. 4 is a chart showing an example of an electrical characteristic of a transistor comprised of an IGBT provided in the ESD protection circuit in Fig. 2. Fig. 5 is a chart showing an example of an electrical characteristic in the ESD protection circuit in Fig. 2. Fig. 6 is a cross section showing an example of the DMOS transistor provided in the ESD protection circuit in Fig. 2. Fig. 7 is a cross section showing an example of the IGBT transistor provided in the ESD protection circuit in Fig. 2.

In the present embodiment, an ECU 1 is mounted in an automobile, for example, and controls various systems such as an engine, an airbag, and an air conditioner and so forth. As shown in Fig. 1, the ECU 1 includes a semiconductor integrated circuit device 2 and a micro computer unit (MCU) 3.

The semiconductor integrated circuit device 2 is an application specific integrated circuit (ASIC), for example, and operates based on the control of the MCU 3. The semiconductor integrated circuit device 2 is coupled to a sensor unit 4 and an actuator unit 5 through harnesses 6 and 7, for example.

The sensor unit 4 is a sensor used for controlling an airbag and detecting collision, for example, and uses an acceleration sensor, for example. The actuator unit 5 is a squib being an ignition device for the airbag. If an automobile collides with an object, the sensor unit 4 detects acceleration and sends the detected information to the ECU 1 through the harness 6. The ECU 1 causes the MCU 3 to determine whether the automobile collides based on the detected information such as acceleration, for example, sent from the sensor unit 4.

If the MCU 3 determines that the automobile collides, current is caused to flow into a squib resistor to ignite and explode gunpowder based on an airbag inflating signal transmitted to the actuator unit 5 through the harness 7.

Since the harnesses 6 and 7 are coupled between predetermined modules in a vehicle compartment, a large ESD noise can be applied on an on-vehicle system. For this reason, the high voltage terminals of the semiconductor integrated circuit device 2 directly coupled to the harnesses 6 and 7 need to have a high resistance to the ESD noise. Noise applied to the harnesses 6 and 7 is not particularly specified, but it is an ESD noise and the like.

Fig. 2 is a circuit diagram showing an example of an ESD protection circuit 8 provided in high voltage terminals of the semiconductor integrated circuit device 2 coupled to the harnesses 6 and 7.

As shown in the figure, the ESD protection circuit 8 includes a clamping circuit 9 being a first clamping circuit, a Zener diode 10 being a second clamping circuit, a Zener diode 11 being a third clamping circuit, a transistor 12 being a first transistor, a transistor 13 being a second transistor, a resistor 14 being a first resistor, and a resistor 15 being a second resistor.

The transistor 12 is comprised of a high withstand voltage transistor element such as a double diffused metal oxide semiconductor (DMOS), for example. One coupling portion of the transistor 12 is coupled to a high voltage terminal ESD_IN being an input/output terminal in the semiconductor integrated circuit device 2.

The clamping circuit 9 is comprised of a plurality of Zener diodes 16 to 20 and coupled between one coupling portion of the transistor 12 and the gate thereof. The clamping circuit 9 is coupled in series between the high voltage terminal ESD_IN of the semiconductor integrated circuit device 2 and the cathode of the Zener diode 10.

The cathode of the Zener diode 10 and one coupling portion of the resistor 14 are coupled to the gate of the transistor 12. A reference potential VSS is coupled to the other coupling portion of the transistor 12 and the other coupling portion of the resistor 14.

The cathode of the Zener diode 11 is coupled to the anode of Zener diode 10 and the anode of the Zener diode 11 is coupled to the reference potential VSS.

The transistor 13 is comprised of IGBT, for example, and absorbs an ESD current. One coupling portion of the transistor 13 is coupled to one coupling portion of the transistor 12 and the high voltage terminal ESD_IN.

The gate of the transistor 13 is coupled to one coupling portion of the resistor 15 and the coupling portion between the Zener diodes 10 and 11. The other coupling portions of the transistor 13 and the resistor 15 are coupled to the reference potential VSS.

The resistor 15 is a resistor for pulling down the gate to turn off the transistor 13 when ESD is not applied. The Zener diode 11 protects the transistor 13 so that the gate voltage of the transistor 13 does not exceed a predetermined voltage.

Here at Fig.2, it is possible to make transistor double as out put transistor by applying the control signal on the gate of transistor 12.

Fig. 3 is a chart showing an example of an electrical characteristic of the transistor 12 comprised of a DMOS.

As shown in the figure, the transistor 12 has a characteristic in which its ability of causing the drain current ID to flow increases according to the gate voltages VG1_DMOS, VG2_DMOS, and VG3_DMOS.

Fig. 4 is a chart showing an electrical characteristic of the transistor 13 comprised of an IGBT.

The IGBT increases a collector current (IC) according to the gate voltage (VG_IGBT) and operates as a thyristor when a collector voltage (VC) exceeds a trigger voltage to lower the collector voltage (VC) to the hold voltage. The thyristor effect decreases an electric power applied to the IGBT to substantially increase the current absorption capacity of the IGBT (the transistor 13).

The IGBT whose trigger voltage higher than the withstand voltage of a protected circuit is used to prevent the protected circuit coupled to the high voltage terminal ESD_IN of the semiconductor integrated circuit device 2 from being broken down.

While on the other hand the thyristor effect increases the current absorption capacity, if a current noise with a comparatively small energy is applied at the time of operating the protected circuit, i.e., at the time of a normal operation, a latch-up occurs, which may cause malfunction. This problem can be solved such that the transistor 12 comprised of the DMOS is caused to absorb the current noise at the time of operating the protected circuit to prevent malfunction due to latchup, and the IGBT (the transistor 13) whose current absorption capacity is increased by the thyristor effect is operated in parallel to allow effectively protecting the protected circuit for a large current at the time of ESD.

The action of the ESD protection circuit 8 in the present embodiment is described below with reference to Fig. 2 and the chart showing an example of an electrical characteristic in the ESD protection circuit 8 in Fig. 5.

When a noise with a comparatively small energy is applied on the high voltage terminal ESD_IN, the current IESD is input. When the drain voltage exceeds the clamping voltage (the voltage V1 in Fig. 5) determined by the clamping circuit 9, current flows in the resistor 14 to increase the gate voltage of the transistor 12, thereby the drain current (ID in Fig. 5) of the transistor 12 starts flowing. The current monotonously increases until the gate voltage of the transistor 12 is equal to the clamping voltage clamped by the Zener diode 10. At this point, the current flows not into the Zener diodes 10 and 11 and the resistor 15, but into the VSS through the resistor 14.

In Fig. 5, the clamping voltage of the Zener diode 10 applied to the gate voltage of the transistor 12 is taken as a voltage VGS2_DMOS. At this point, the gate of the transistor 13 is pulled down by the resistor 15 and the transistor 13 is turned off.

When the noise whose energy is high such as ESD and the gate voltage of the transistor 12 exceeds the voltage VG2_DMOS, which exceeds the clamping voltage of the Zener diode 10 to start current flowing into the resistor 15 through the Zener diode 10, increasing the gate voltage of the transistor 13, which starts a collector current IC flowing.

The collector current IC and the collector voltage VC increase according as the gate voltage of the transistor 13 increases. Since the gate voltage of the transistor 12 also increases, the drain current ID also increases, and the current IESD becomes equal to the sum of the collector current IC and the drain current ID.

When the gate voltage of the transistor 13 increases and its collector voltage VC reaches an IGBT trigger voltage, the transistor 13 starts operating as a thyristor to lower the collector voltage VC to a hold voltage.

The transistor 13 operating as a thyristor decreases electric power supplied thereto, thereby substantially increasing the current absorption capacity of the transistor 13. Thus, the DMOS transistor 12 is caused to absorb the current noise in a small current region in operating the protected circuit to prevent malfunction due to latch-up and the transistor 13 comprised of the IGBT whose current absorption capacity is increased by the thyristor effect is operated in parallel to prevent malfunction in operating the protected circuit without the area of the ESD protection circuit being increased and allow effectively protecting the protected circuit even when a large ESD current is applied. As shown in Fig. 5, the ESD withstand voltage is determined by current at which the IGBT causes thermal destruction.

Only the DMOS is operated in a region of a small current to be applied and the IGBT with the thyristor effect is operated in parallel in a region of a large current, thereby allowing preventing malfunction in operating the protected circuit and effectively protecting it even when a large ESD current is applied. Furthermore, as shown in Fig. 5, the ESD withstand voltage is determined by current at which the IGBT causes thermal destruction.

Fig. 6 is a cross section showing an example of the transistor 12 comprised of the DMOS.

In the transistor 12, an N+ type semiconductor region 22 is formed on a P- type semiconductor substrate 21 and an NWELL region 23 the impurity density of which is lower than that of the N+ type semiconductor region 22 is formed over the N+ type semiconductor region 22.

N type semiconductor regions 24 and 25 are formed in the upper left and right positions of the NWELL region 23. A P type semiconductor region 26 is formed in the upper center position of the NWELL region 23.

An N type semiconductor region 27 the impurity density of which is higher than that of the N type semiconductor region 24 is formed between oxide films 28 and 29 over the N type semiconductor region 24. An N type semiconductor region 30 the impurity density of which is higher than that of the N type semiconductor region 25 is formed between oxide films 31 and 32 over the N type semiconductor region 25. The N type semiconductor regions 27 and 30 function as the drain of the transistor 12.

An N type semiconductor region 33, a P type semiconductor region 34, and an N type semiconductor region 35 are formed from left to right over the P type semiconductor region 26. The N type semiconductor region 33, the P type semiconductor region 34, and the N type semiconductor region 35 function as the source of the transistor 12.

A gate 37 is formed through an oxide film 36 over the upper left position of the P type semiconductor region 26. A gate 39 is formed through an oxide film 38 over the upper right position of the P type semiconductor region 26.

Fig. 7 is a cross section showing an example of the transistor 13 comprised of the IGBT.

As shown in Fig. 7, P type semiconductor regions 40 and 41 are formed in the transistor 13 instead of the N type semiconductor regions 27 and 30 in the transistor 12 (refer to Fig. 6). Other components are similar to those of the transistor 12, so that the description thereof is omitted.

The P type semiconductor regions 40 and 41 can be formed simultaneously with the P type semiconductor region 34 functioning as the source of the transistor 13, so that the transistor 13 can be produced without the addition of a new process.

According to the first embodiment, the ESD withstand voltage can be increased without the size of the ESD protection circuit 8 being increased.

In the present embodiment, although the transistor 13 uses the IGBT element with a thyristor characteristic, an element with a snapback characteristic such as a VDMOS, for example, may be used to obtain a similar effect.

The inventions made by the inventors are described in detail above based on the embodiments. It should be understood that the present invention is not limited to the foregoing embodiments, but various modifications may be made without departing from the gist of the present invention.

Although the above embodiments describe the semiconductor integrated circuit device used in the ECU module for an automobile, the ESD protection circuit of the present invention is also applicable not only to an on-vehicle semiconductor integrated circuit device but also to a general semiconductor integrated circuit device required to have a high ESD withstand voltage.

The present invention is suited for an ESD protection technique in a semiconductor integrated circuit device required to have a high ESD withstand voltage.

## Claims

1. A semiconductor integrated circuit device comprising an ESD protection circuit for protecting against ESD at an input/output terminal thereof,
wherein the ESD protection circuit includes:
a first clamping circuit one terminal of which is coupled to the input/output terminal;
a second clamping circuit one terminal of which is coupled to the output portion of the first clamping circuit;
a third clamping circuit one terminal of which is coupled to the output portion of the second clamping circuit and the other terminal of which is coupled to a reference potential;
a first transistor one coupling portion of which is coupled to the input/output terminal, the other coupling portion of which is coupled to the reference potential and the gate of which is coupled to the other terminal of the first clamping circuit;
a second transistor one coupling portion of which is coupled to the input/output terminal, the other coupling portion of which is coupled to the reference potential and the gate of which is coupled to the other terminal of the second clamping circuit;
a first resistor coupled between the gate of the first transistor and the reference potential; and
a second resistor coupled between the gate of the second transistor and the reference potential.

2. The semiconductor integrated circuit device according to claim 1,
wherein the second resistor is any one of an IGBT, a VDMOS, an LDMOS, or a thyristor.

3. The semiconductor integrated circuit device according to claims 1 or 2,
wherein each of the first to the third clamping circuit includes one or more Zener diodes coupled in the reverse direction.

4. The semiconductor integrated circuit device according to claims 1 or 2,
wherein each of the first to the third clamping circuit includes one or more diodes coupled in the forward direction.

5. The semiconductor integrated circuit device according to claims 1 or 2,
wherein each of the first to the third clamping circuit includes one or more diodes in which a MOS transistor is diode-connected and which are coupled in the forward direction.
